Europäisches Patentamt

European Patent Office

Office européen des brevets

(11) Veröffentlichungsnummer : **0 038 519 B1**

(12) **EUROPÄISCHE PATENTSCHRIFT**

(45) Veröffentlichungstag der Patentschrift :
08.02.84

(51) Int. Cl.³ : **H 03 C 3/22**

(21) Anmeldenummer : 81102864.6

(22) Anmeldetag : 14.04.81

(54) **Modulierbarer Transistoroszillator grosser Leistung.**

(30) Priorität : 21.04.80 DE 3015272

(43) Veröffentlichungstag der Anmeldung :
28.10.81 Patentblatt 81/43

(45) Bekanntmachung des Hinweises auf die Patenterteilung : 08.02.84 Patentblatt 84/06

(84) Benannte Vertragsstaaten :
AT BE CH FR GB IT LI LU NL SE

(56) Entgegenhaltungen :
DE-A- 1 541 385
DE-B- 2 637 360
US-A- 3 535 656
Patents Abstracts of Japan, Vol. 2, Nr. 116, 27. September 1978, Seite 6607E78

(73) Patentinhaber : **SIEMENS AKTIENGESELLSCHAFT**
**Berlin und München Wittelsbacherplatz 2**
**D-8000 München 2 (DE)**

(72) Erfinder : **Amend, Wilhelm, Dipl.-Ing.**
**Am Georgenstein 4**
**D-8021 Baierbrunn (DE)**
Erfinder : **Klüh, Udo, Dipl.-Ing.**
**Auenstrasse 2 E**
**D-8190 Wolfratshausen (DE)**
Erfinder : **Pichon, Walter**
**Hauzenberger Strasse 20**
**D-8000 München 21 (DE)**

## Modulierbarer Transistoroszillator großer Leistung

Die Erfindung bezieht sich auf einen modulierbaren Transistoroszillator großer Leistung für den Bereich sehr hoher Frequenzen mit einem frequenzbestimmenden Koaxialresonator und einem an diesen angekoppelten Transistor in Kollektorschaltung (Oszillator-Transistor).

Durch die DE-BZ-26 37 360 ist ein Transistor-Oszillator für höhere Frequenzen bekannt, der einen frequenzbestimmenden Koaxialresonator und einen an diesen angekoppelten Transistor in Kollektorschaltung mit unmittelbar geerdetem Kollektor und Auskopplung der HF-Energie vom Emitter aufweist. Die Auskopplung der HF-Energie erfolgt dabei über ein abwärtstransformierendes Netzwerk. Als weitere Maßnahme zur Erreichung eines minimalen Phasenrauschens ist dabei vorgesehen, daß der Koaxialresonator kapazitiv an einem Basisanschluß und Masse liegt und daß ein zweiter Basisanschluß des Transistors sowie dessen Emitteranschluß je über eine etwa $\lambda/4$ lange, in ihrer Länge veränderbar ausgeführte Leitung an die Vorspannungsquelle gelegt sind.

Richtfunksysteme mit Kanalzahlen bis zu etwa 300 Sprechkreisen werden überwiegend für kurze Entfernungen mit 1 bis 5 Funkfeldern betrieben. Bei Verwendung derartiger Systeme für Weitverkehrsverbindungen werden in der Regel auf jeder Zwischenstelle einzelne Kanäle abgezweigt bzw. neu eingespeist, d. h. es ist eine Demodulation bzw. Modulation des Basisbandes je Zwischenstelle erforderlich. Man ist daher bestrebt, diese Schmalbandsysteme als direkt modulierte Geräte mit direkter Modulation des Radiofrequenz-Trägers unter Verzicht auf den Modulator in der Zwischenfrequenz-Lage aufzubauen. Bei der Modulation in einem Oszillator kleiner Leistung ist ein nachgeschalteter Leistungsverstärker erforderlich, was einen erhöhten Platzbedarf und höhere Kosten verursacht.

Der Erfindung liegt die Aufgabe zugrunde, einen modulierbaren Transistoroszillator einfachen Aufbaus zu schaffen, bei dem die modulierte Radiofrequenz in einem einstufigen Leistungsoszillator erzeugt werden kann bei einer möglichst verzerrungsfreien Erzeugung des erforderlichen Frequenzhubs bei hohem Leistungspegel des RF-Oszillators und möglichst geringem thermischen Geräusch.

Diese Aufgabe wird bei einem modulierbaren Transistoroszillator der eingangs beschriebenen Art gemäß der Erfindung in der Weise gelöst, daß das verstärkte Basisbandsignal dem Oszillator-Transistor gleichphasig einerseits über einen Vorspannungstransistor zugeführt ist, der über einen Kondensator mit dem Basisbandsignaleingang verbunden ist, und die Basisvorspannung des Oszillator-Transistors moduliert und andererseits über eine Modulationsdiode zugeführt ist und im Resonator die Frequenz des Oszillator-Transistors ändert.

Vorteilhafte Ausgestaltungen und Weiterbildungen des Erfindungsgegenstandes sind in den abhängigen Ansprüchen angegeben.

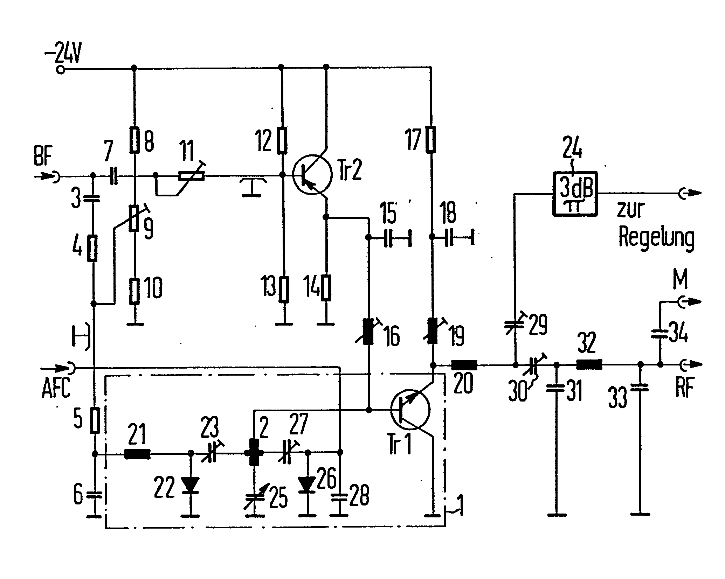

Weitere Einzelheiten der Erfindung werden nachstehend anhand eines in der Zeichnung dargestellten Ausführungsbeispiels näher erläutert.

Die Figur zeigt das Schaltbild des modulierbaren Leistungsoszillators, der nach dem Prinzip des emittergekoppelten Oszillators funktioniert. Die RF-Leistung (ca. 1,5 Watt bei 1,8 GHz) wird im Transistor Tr1 erzeugt. Der Transistor ist in dem strichpunktiert angedeuteten, als Koaxialresonator ausgebildeten Resonator 1 untergebracht. Der Kollektor des Transistors Tr1 liegt auf Masse, die Basis ist an den Innenleiter 2 des Koaxialresonators angeschraubt. An den Innenleiter 2 des Koaxialresonators ist ferner ein einseitig auf Masse liegender Tauchkondensator 25 angeschlossen, über den die Abstimmung des Oszillators auf die RF-Kanäle erfolgt. Vom Prüffeld einstellbare Anschläge begrenzen den Durchstimmbereich. Die RF-Leistung wird aus dem Emitter des Transistors Tr1 über ein Anpassungsnetzwerk ausgekoppelt, bestehend aus der Induktivität 20 und dem Koppelkondensator 30.

Diesem nachgeschaltet ist ein Tiefpaß aus der Induktivität 32 und den Kondensatoren 31 und 33, der den Oberwellenabstand verbessert. Über einen Kondensator 34, der an die zum RF-Ausgang führende Leitung angeschlossen ist, ist eine Frequenzmeßbuchse M angekoppelt. Der Leistungsoszillator wird über eine Phasenregelung mit Synthesizer quarzstabil in seiner Mittenfrequenz synchronisiert. Für diese Regelung wird von der Induktivität 20 des Anpassungsnetzwerkes aus über einen Kondensator 29 und ein 3-dB-Dämpfungsglied 24 ein kleiner Teil der RF-Leistung ausgekoppelt. Die Regelspannung (Eingang AFC) wirkt im RF-Oszillator auf die Regeldiode 26, die über einen Koppelkondensator 27 an den Resonator angekoppelt ist.

Das vom BF-Verstärker (Eingang BF) kommende Basisbandsignal wird dem Oszillator auf zwei gleichphasigen Wegen zugeführt : einerseits wird über einen Vorspannungstransistor Tr2 die Basisvorspannung des RF-Transistors Tr1 moduliert, andererseits wird über eine kapazitiv angekoppelte Modulationsdiode 22 die Frequenz des Resonators geändert. Der Vorspannungstransistor Tr2 erhält das Basisbandsignal über einen Kondensator 7 und ein Potentiometer 11. Der Kondensator 7 ist so dimensioniert, daß für die tiefste Meßfrequenz der Spannungsabfall an ihm klein ist gegenüber der Spannung am Widerstand R13, d. h. des in der Emitter-Basis-Strecke des Vorspannungstransistors Tr2 liegenden Widerstandes des hochohmigen Spannungsteilers 12, 13. Zur Modulationsdiode 22 gelangt das Basisbandsignal über einen Kondensator 3, zwei ohmsche Widerstände 4, 5 und eine Induktivität 21. Die Vorspannung der Modulationsdiode 22 ist über ein Potentiometer 9 einstellbar, das mit Widerständen 8, 10 zwischen der Vorspannungsquelle und Massepotential in Serie liegt und dessen Abgriff an den Verbindungspunkt der Widerstände 4, 5 im Zuleitungsweg des Basisbandsignals zur Modulationsdiode 22 geführt ist. Die Ankopplung der Modulationsdiode 22 an den Resonator erfolgt über einen mit dem Innenleiter 2 verbundenen Kondensator 23. Weitere ohmsche, induktive und kapazitive Elemente der Schaltung, die zur Erläuterung der Funktion des erfindungsgemäßen Transistoroszillators nicht unbedingt erforderlich sind, sind nicht näher beschrieben.

Im erfindungsgemäßen modulierbaren Leistungsoszillator erfolgt also die Modulation des RF-Transistors über zwei Wege, nämlich einerseits über die Modulationsdiode und andererseits über den Vorspannungstransistor. Beide Modulationswege bzw. Modulationseinrichtungen arbeiten gleichphasig und ergänzen sich bei der Erzeugung des Frequenzhubs. Durch die Aufteilung der Modulation auf die zwei Wege wird erreicht, daß die Modulationsdiode wesentlich loser angekoppelt werden kann als in dem Fall, wo sie allein den ganzen Frequenzhub bewirken müßte. Durch die lose Ankopplung ist die Güte des Oszillators höher und das thermische Geräusch bleibt klein. Gegenüber einer alleinigen Modulation über den Vorspannungstransistor hat die Aufteilung den Vorteil geringerer Klirrgeräusche, da die Modulation durch die Kombination von Modulationsdiode und Vorspannungstransistor linearer erfolgt. Die Steilheitsverzerrungen in den beiden Wegen lassen sich durch geeignete Wahl der Ankopplungen und Arbeitspunkte weitestgehend kompensieren.

**Ansprüche**

1. Modulierbarer Transistoroszillator großer Leistung für den Bereich sehr hoher Frequenzen mit einem frequenzbestimmenden Koaxialresonator (1) und einem an diesen angekoppelten Transistor (Tr1) in Kollektorschaltung (Oszillator-Transistor), dadurch gekennzeichnet, daß das verstärkte Basisbandsignal dem Oszillator-Transistor (Tr1) gleichphasig einerseits über einen Vorspannungstransistor (Tr2) zugeführt ist, der über einen Kondensator (7) mit dem Basisbandsignaleingang (BF) verbunden ist, und die Basisvorspannung des Oszillator-Transistors (Tr1) moduliert und andererseits über eine Modulationsdiode (22) zugeführt ist und im Resonator (1) die Frequenz des Oszillator-Transistors (Tr1) ändert.

2. Transistoroszillator nach Anspruch 1, dadurch gekennzeichnet, daß der Kondensator (7) im Weg des Basisbandsignals zum Vorspannungstransistor (Tr2) so dimensioniert ist, daß für die tiefste Meßfrequenz der Spannungsabfall an ihm klein ist gegen die steuernde Spannung am Widerstand (R13) (Emitter-Basis-Strecke des Vorspannungstransistors (Tr2)).

3. Transistoroszillator nach Anspruch 1 oder 2, dadurch gekennzeichnet, daß die Modulationsdiode (22) kapazitiv an den Ausgang eines das Basisbandsignal verstärkenden Verstärkers angekoppelt ist.

4. Transistoroszillator nach einem der Ansprüche 1 bis 3, dadurch gekennzeichnet, daß die HF-Leistung vom RF-Transistor (Tr1) über ein Anpassungsnetzwerk (20, 30) ausgekoppelt wird.

5. Transistoroszillator nach Anspruch 4, dadurch gekennzeichnet, daß dem Anpassungsnetzwerk (20, 30) ein Tiefpaß (31, 32, 33) nachgeschaltet ist.

6. Transistoroszillator nach einem der Ansprüche 1 bis 5, dadurch gekennzeichnet, daß der Leistungsoszillator über eine Phasenregelung (AFC) mit Synthesizer in seiner Mittenfrequenz synchronisiert ist.

7. Transistoroszillator nach Anspruch 6, dadurch gekennzeichnet, daß die von einem ausgekoppelten Teil der RF-Leistung abgeleitete Regelspannung auf eine an den Resonator (1) angekoppelte Regeldiode (26) gegeben wird.

**Claims**

1. A modulatable high power transistor v. h. f. oscillator having a frequency-determining coaxial resonator (1) and a transistor (Tr1) coupled to the resonator and connected as a common collector stage (oscillator transistor), characterised in that the amplified base band signal is fed to the oscillator transistor (Tr1) in equal phase on the one hand via a bias voltage transistor (Tr2) which is connected via a capacitor (7) to the base-band signal input (BF) and which modulates the base bias voltage of the oscillator transistor (Tr1), and on the other hand is applied across a modulation diode (22) and changes the frequency of the oscillator transistor (Tr1) in the resonator (1).

2. A transistor oscillator as claimed in Claim 1, characterised in that the capacitor (7) arranged in the path of the base-band signal to the bias voltage transistor (Tr2) is dimensioned in such manner that for the lowest measuring frequency the voltage drop across it is small in relation to the controlling voltage connected to the resistor (R13) (emitter-base-path of the bias voltage transistor (Tr2)).

3. A transistor oscillator as claimed in Claim 1 or 2, characterised in that the modulation diode (22) is capacitively coupled to the output of an amplifier which amplifies the base-band signal.

4. A transistor oscillator as claimed in one of the Claims 1 to 3, characterised in that the HF-power is output-coupled from the RF-transistor (Tr1) via a matching network (20, 30).

5. A transistor oscillator as claimed in Claim 4, characterised in that a low-pass filter (31, 32, 33) is connected to the output end of the matching network (20, 30).

6. A transistor oscillator as claimed in one of the Claims 1 to 5, characterised in that the power oscillator is synchronised with a synthesiser at its middle frequency via a phase regulating unit (AFC).

7. A transistor oscillator as claimed in Claim 6, characterised in that the regulating voltage derived from an output-coupled component of the RF-power is fed to a regulating diode (26) coupled to the resonator (1).

## Revendications

1. Oscillateur à transistor modulable de grande puissance pour le domaine des très hautes fréquences comportant un résonateur coaxial déterminant la fréquence et un transistor (Tr1) raccordé à ce résonateur et monté au collecteur commun (transistor de l'oscillateur), caractérisé par le fait que le signal amplifié de bande de base est envoyé en phase au transistor (Tr1) de l'oscillateur d'une part par l'intermédiaire d'un transistor (Tr2) fournissant la tension de polarisation et qui est relié par l'intermédiaire d'un condensateur (7) à l'entrée (BF) des signaux de bande de base, et module la tension de polarisation de la base du transistor (Tr1) de l'oscillateur, et est envoyé d'autre part au transistor (Tr1) de l'oscillateur par l'intermédiaire d'une diode de modulation (22) et modifie la fréquence de cet oscillateur dans le résonateur (1).

2. Oscillateur à transistor suivant la revendication 1, caractérisé par le fait que le condensateur (7) situé dans la voie du signal de bande de base aboutissant au transistor (Tr2) délivrant la tension de polarisation est dimensionné de telle sorte que pour la fréquence de mesure la plus basse, la chute de tension à ses bornes est faible par rapport à la tension de commande aux bornes de la résistance (R13) (voie émetteur-base du transistor (Tr2) de délivrance de la tension de polarisation).

3. Oscillateur à transistor suivant la revendication 1 ou 2, caractérisé par le fait que la diode de modulation (22) est couplée de façon capacitive à la sortie d'un amplificateur amplifiant le signal de bande de base.

4. Oscillateur à transistor suivant les revendications 1 à 3, caractérisé par le fait que la puissance à haute fréquence du transistor à fréquence radioélectrique (Tr1) est découplée par l'intermédiaire d'un réseau d'adaptation (20, 30).

5. Oscillateur à transistor suivant la revendication 4, caractérisé par le fait qu'un filtre passe-bas (31, 32, 33) est branché en aval du réseau d'adaptation (20, 30).

6. Oscillateur à transistor suivant l'une des revendications 1 à 5, caractérisé par le fait que la fréquence centrale de l'oscillateur de puissance est synchronisée par l'intermédiaire d'une régulation de phase (AFC) avec un synthétiseur.

7. Oscillateur à transistor suivant la revendication 6, caractérisé par le fait que la tension de réglage dérivée d'une partie découplée de la puissance à fréquence radioélectrique est envoyée à une diode de réglage (26) accouplée au résonateur (1).